Europäisches Patentamt

European Patent Office

Office européen des brevets

(19)

(11) Numéro de publication : **0 021 872**
**B1**

(12) **FASCICULE DE BREVET EUROPÉEN**

(45) Date de publication du fascicule du brevet :
**18.01.84**

(21) Numéro de dépôt : **80400674.0**

(22) Date de dépôt : **14.05.80**

(51) Int. Cl.³ : **G 01 S 7/02**, G 01 S 13/50,
**H 03 D 9/06**

(54) Tête hyperfréquence d'émission et de réception simultanées, émetteur-récepteur en ondes millimétriques et radar utilisant une telle tête.

(30) Priorité : **12.06.79 FR 7914990**

(43) Date de publication de la demande :
**07.01.81 Bulletin 81/01**

(45) Mention de la délivrance du brevet :
**18.01.84 Bulletin 84/03**

(84) Etats contractants désignés :
**DE GB NL**

(56) Documents cités :
**DE-B- 1 137 486**
**FR-A- 1 188 636**
**FR-A- 2 177 432**
**FR-A- 2 318 514**
**FR-A- 2 423 088**
**US-A- 3 181 148**
**IEEE TRANSACTIONS ON MICROWAVE THEORY AND TECHNIQUES, vol. 24, no. 1, janvier 1976, New York, US A. HISLOP et al.: "A broad-band 40-60 GHz balanced mixer", pages 63, 64**
**IEEE INTERNATIONAL SOLID STATE CIRCUITS CONFERENCE, vol. 22, février 1979, New York, US, G. CACHIER et al.: "Modular techniques for controlling the frequency of millimeter IMPATTS", pages 170, 171**

(73) Titulaire : **THOMSON-CSF**
**173, Boulevard Haussmann**
**F-75379 Paris Cedex 08 (FR)**

(72) Inventeur : **Cachier, Gérard**
**"THOMSON-CSF" SCPI - 173, Bld. Haussmann**
**F-75360 Paris Cedex 08 (FR)**

(74) Mandataire : **Benoit, Monique et al**
**THOMSON-CSF SCPI 173, Bld Haussmann**
**F-75379 Paris Cedex 08 (FR)**

## Tête hyperfréquence d'émission et de réception simultanées, émetteur-récepteur en ondes millimétriques et radar utilisant une telle tête

L'invention concerne une tête hyperfréquence d'émission et de réception simultanée ainsi qu'un émetteur-récepteur et un radar en ondes millimétriques utilisant une telle tête.

Le but de l'invention est de réaliser simultanément, avec des moyens relativement simples et peu coûteux, un émetteur-récepteur compact et de hautes performances, notamment en ce qui concerne le rapport signal à bruit à la réception.

Une tête hyperfréquence d'émission et de réception comprend généralement en un seul ensemble : un oscillateur susceptible d'être utilisé à la fois comme source d'émission et comme oscillateur local, plusieurs guides d'ondes, des jonctions entre ces différents guides et un mélangeur symétrique. L'une de ces jonctions permet notamment la répartition de l'onde émise et de l'onde reçue. Cet élément est indispensable au bon fonctionnement de la tête puisque les ondes d'émission et de réception transitent par une partie de la tête qui leur est commune. Il est connu, en particulier par le brevet américain US-A-3 181 148, de réaliser l'élément répartiteur de faisceaux par un circuit hybride (ou T magique). Un circuit hybride est une jonction de quatre guides d'ondes identiques qui peut être réalisé relativement facilement dans le cas des microondes. Dans le cas des ondes millimétriques, une technologie différente s'impose du fait de la miniaturisation de la tête. En effet une structure compacte est mieux appropriée dans ce cas et l'invention propose de remplacer le circuit hybride de l'art connu par la jonction de trois guides d'ondes de sections différentes. Un autre avantage de l'invention est d'éviter l'utilisation d'un guide d'onde tordu à 90° comme c'est le cas du document cité.

L'invention a donc pour objet une tête hyperfréquence comportant au moins un générateur d'ondes millimétriques susceptible d'être utilisé à la fois comme source d'émission et comme oscillateur local, un mélangeur symétrique dont les sorties sont destinées à être connectées aux entrées d'un amplificateur de réception, plusieurs portions de guides d'ondes véhiculant les ondes émises et reçues et deux jonctions coopérant avec des tronçons desdits guides d'ondes ; caractérisée en ce que l'une desdites jonctions est un duplexeur de polarisation constitué par la jonction de trois guides d'onde : un premier guide et un second guide à sections rectangulaires, un troisième guide à section carrée servant de voie à double sens ; lesdits premier et deuxième guides étant disposés de telle sorte que les composantes électriques des champs électromagnétiques soient orthogonales ; ledit générateur alimentant l'un des guides à sections rectangulaires ; l'autre jonction étant constituée par l'interférence desdits premier et second guides au voisinage dudit mélangeur ; ladite tête formant un seul bloc.

L'invention sera mieux comprise, et d'autres caractéristiques apparaîtront au moyen de la description qui suit, et des dessins qui l'accompagnent, parmi lesquels :

la figure 1 est un schéma de réalisation de l'invention ;

la figure 2 représente en coupe une tête suivant l'invention ;

la figure 3 représente selon une coupe analogue à la précédente une variante de l'invention.

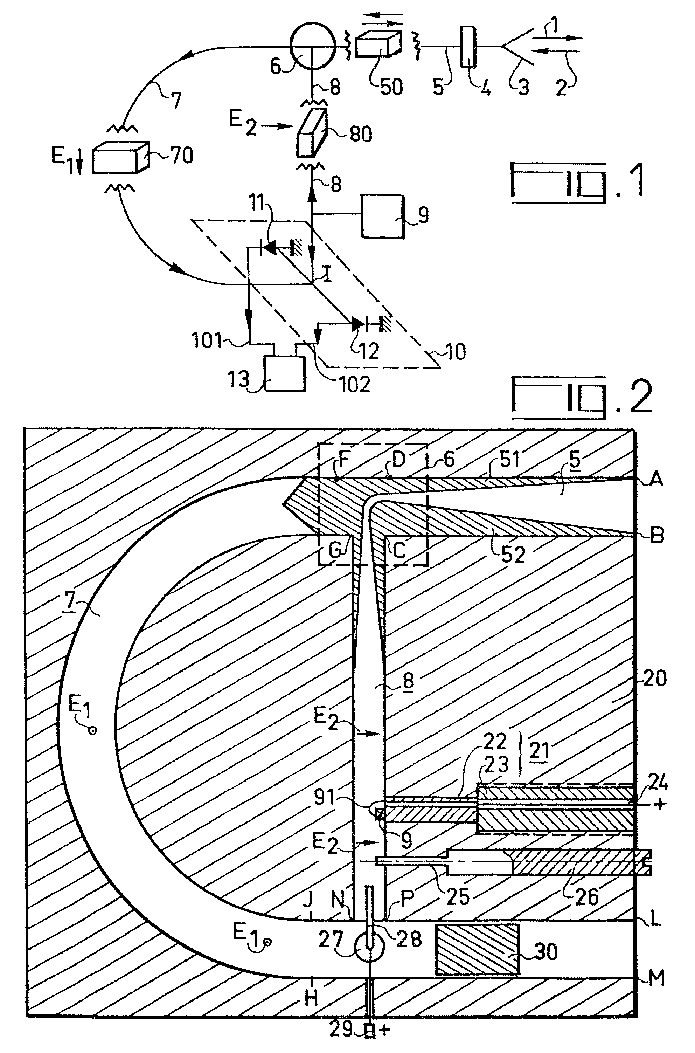

Un émetteur-récepteur (figure 1) comporte par exemple un oscillateur 9 jouant le rôle simultané de source d'émission et d'oscillateur local, un duplexeur 6, un mélangeur symétrique 10 et un récepteur 13. Le duplexeur 6 et le mélangeur 10 sont représentés suivant des symboles usuels. L'oscillateur 9 et le récepteur 13 sont figurés par de simples rectangles.

Deux guides 7 et 8 sont raccordés en polarisations croisées au duplexeur 6, lui-même raccordé à un troisième guide 5 à section carrée figurée par un tronçon symbolique 50. Dans ce tronçon 50 se propagent en sens inverse, les ondes d'émission et de réception à polarisations mutuellement orthogonales.

Les tronçons symboliques 70 et 80 représentés sur des interruptions des guides 7 et 8 montrent que les petits côtés de ces guides sont orthogonaux. Au point de couplage des deux guides, les composantes électriques $E_1$ et $E_2$ des champs électromagnétiques sont parallèles aux petits côtés des sections droites des guides et donc orthogonales.

L'émetteur-récepteur est complété par une lame 4 dite quart d'onde, destinée à transformer, de façon classique la polarisation linéaire en polarisation circulaire et inversement. La présence de cette lame n'est qu'éventuelle et destinée à permettre l'utilisation de la tête hyperfréquence en radar.

Enfin, un aérien 3, par exemple du type en cornet, est raccordé au guide 5. On a représenté par des flèches 1 et 2 les ondes millimétriques se propageant en sens inverse à l'extérieur de la tête.

En fonctionnement, l'onde 1 engendrée par l'oscillateur 9 est propagée par le guide 8 jusqu'au duplexeur 6 où elle est aiguillée sur le guide 5 et de là vers l'aérien 3. Elle n'interfère pas avec l'onde 2 du signal à recevoir dirigée par le duplexeur 6 sur le guide 7 aboutissant par une portion en arc de cercle au point I où le mélangeur 10 reçoit en outre par couplage avec le guide 8, par des moyens non représentés, le champ électromagnétique du signal local provenant de l'oscillateur 9. Les sorties 101 et 102 du mélangeur sont connectées à un récepteur 13 effectuant la différence ou la somme des signaux détectés suivant que ceux-ci sont en phase ou en opposition de phase.

Dans une liaison entre deux émetteurs-récepteurs selon l'invention, des dispositions sont prises pour assurer l'orthogonalité des polarisations des champs électromagnétiques des ondes 1 et 2. Si les appareils sont semblablement installés, l'un des guides 5 doit être tordu en hélice de 90° sur un seul des émetteurs-récepteurs.

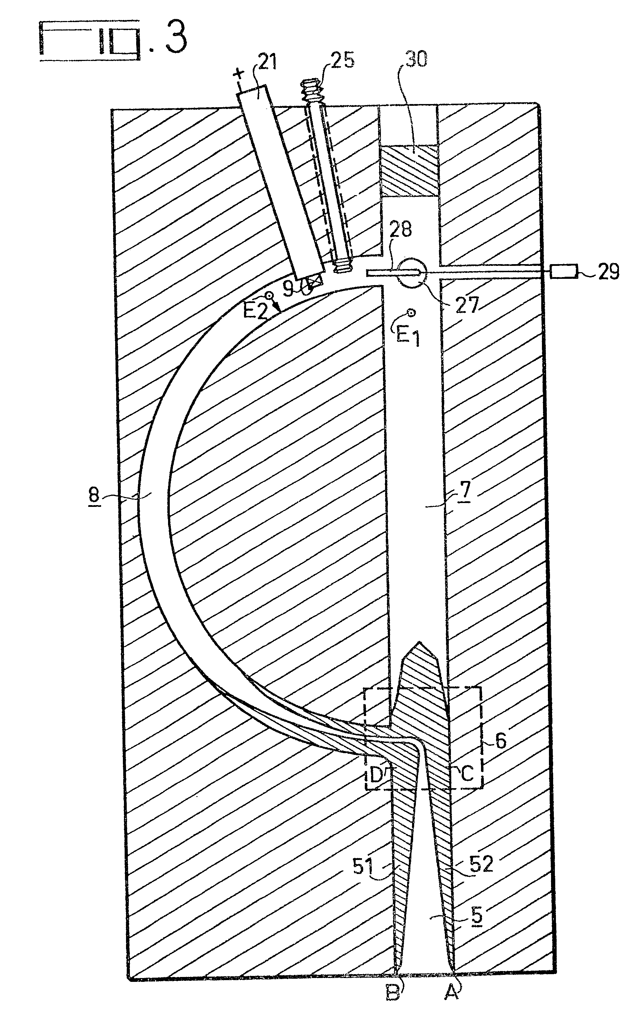

La tête proprement dite de l'émetteur-récepteur, schématisée figure 1, comporte un bloc 20, figure 2, réalisé dans la technologie des circuits et cavités hyperfréquences en partie démontables. Sont intégrés dans ce bloc les trois guides 5, 7 et 8 du circuit de la figure 1 :

— le guide 5, à section carrée, s'étend sur un tronçon ABCD ; il comporte des ailerons 51 et 52 qui facilitent le guidage du champ électrique dans le duplexeur 6 ;

— le guide 7, à section rectangulaire (petit côté du rectangle perpendiculaire au plan de coupe de la figure 2) comportant un tronçon FGHJ coudé en U et un tronçon droit HJLM ;

— le guide 8, à section rectangulaire (petit côté du rectangle parallèle au plan de la figure 2) s'étendant sur un tronçon CGNP.

Dans le plan d'intersection des tronçons 7 et 8, une ouverture NP est pratiquée dans le guide 7 ; à titre d'exemple cette ouverture peut correspondre exactement à l'intersection des deux guides.

L'oscillateur hyperfréquence 9, représenté symboliquement, est introduit dans le guide 8 par un support 21 comportant un manchon fileté 23, vissé dans le bloc 20, et une tige 22 coulissant dans une perforation appropriée du bloc 20. Cet oscillateur est par exemple une diode Gunn dont une électrode est à la masse et l'autre alimentée par une connexion 91 de polarisation, formant une boucle rayonnante dans le guide 8, et par ailleurs traversant la tige 22 et le manchon 23 par un conduit 24.

L'oscillateur peut aussi être constitué par un module comportant un support conducteur, une diode semiconductrice, par exemple à avalanche, au contact de ce support par une de ses électrodes, une couche de matériau diélectrique placé sur ce support et entourant la diode, et une métallisation déposée sur cette couche et en contact avec l'autre électrode de la diode.

L'oscillateur peut également comporter un deuxième module dont la métallisation est disposée vis-à-vis de la métallisation du premier. Mais le deuxième module comprend une diode à capacité variable. Dans les conditions précisées dans le brevet N° 78 11 059 déposé en FRANCE par la demanderesse le 14 avril 1978, on peut faire varier la fréquence de l'oscillateur en agissant sur la polarisation du deuxième module.

Enfin une vis diélectrique 25, portée par un mandrin 26, émerge dans le tronçon du guide 8 ; en réglant la hauteur de saillie de cette vis, on corrige les désadaptations éventuelles entre oscillateur et guide.

Le mélangeur symétrique, comportant par exemple deux diodes tête-bêche, incluses dans des modules en vis-à-vis par leur métallisation 27, est couplé directement à la composante électrique $E_1$ du champ électromagnétique du signal à recevoir et, par l'intermédiaire de bandes conductrices 28 (dont une seule est représentée) à la composante $E_2$ du signal local. Les signaux de sortie du mélangeur sont recueillis sur des électrodes 29 (dont une seule est représentée) servant également à connecter les polarisations.

Un corps conducteur formant un bouchon mobile 30 permet d'accorder au mieux les guides au niveau du mélangeur.

Figure 3, on a représenté une variante de la tête représentée figure 2. On y retrouve les mêmes éléments portant les mêmes repères. Toutefois, le guide 7 du signal à recevoir est ici rectiligne et placé dans le prolongement du guide 5, tandis que le guide 8 est courbé en U. Le mélangeur est dans le guide 7. Il y a donc permutation des guides rectangulaires raccordés au duplexeur.

**Revendications**

1. Tête hyperfréquence comportant au moins un générateur d'ondes millimétriques (9) susceptible d'être utilisé à la fois comme source d'émission et comme oscillateur local, un mélangeur symétrique (10) dont les sorties (101 et 102) sont destinées à être connectées aux entrées d'un amplificateur de réception (13), plusieurs portions de guides d'ondes véhiculant les ondes émises et reçues et deux jonctions coopérant avec des tronçons desdits guides d'ondes ; caractérisée en ce que l'une desdites jonctions (6) est un duplexeur de polarisation constitué par la jonction de trois guides d'onde : un premier guide (7) et un second guide (8) à sections rectangulaires, un troisième guide (5) à section carrée servant de voie à double sens ; lesdits premier et deuxième guides étant disposés de telle sorte que les composantes électriques des champs électromagnétiques soient orthogonales ; ledit générateur alimentant l'un des guides à sections rectangulaires ; l'autre jonction étant constituée par l'intersection desdits premier et second guides au voisinage dudit mélangeur ; ladite tête formant un seul bloc (20).

2. Tête hyperfréquence selon la revendication 1, caractérisée en ce que l'un desdits premier ou second guide présente longitudinalement une forme courbe.

3. Tête suivant l'une quelconque des revendications 1 et 2, caractérisée en ce que le mélangeur comporte deux diodes (11, 12) incluses dans deux modules, placées de telle sorte que leurs métallisations soient en regard l'une de l'autre.

4. Tête suivant l'une des revendications 1 à 3, caractérisée en ce que l'oscillateur est constitué par un module à résistance négative, comportant un support conducteur, une diode semiconductrice au contact de ce support par une de ses électrodes, une couche de matériau diélectrique placée sur ce support et entourant la diode, et une métallisation déposée sur cette couche et en contact avec l'autre électrode de la diode.

5. Tête suivant la revendication 4, caractérisée en ce que l'oscillateur comporte en outre un deuxième module contenant une diode à capacité variable.

6. Emetteur-récepteur comportant une tête suivant l'une des revendications 1 et 2, caractérisé en ce qu'il comporte en outre un aérien (3) en cornet raccordé au guide à section carrée.

7. Radar comportant une tête suivant l'une des revendications 1 et 2, caractérisé en ce qu'il comporte un aérien (3) en cornet raccordé au guide à section carrée, et, en outre, une lame quart d'onde (4) placée entre ledit guide à section carrée et l'aérien.

## Claims

1. Hyperfrequency stage comprising at least one millimeter waves generator (9) susceptible to be used as a transmitter source and as a local oscillator as well, a symmetrical mixer (10) the outputs (101 and 102) of which are to be connected to the inputs of a receiver amplifier (13), a plurality of waveguide portions wherein the transmitted and received waves circulate, and two junctions cooperating with sections of said waveguides ; characterized in that one of said junctions (6) is a polarization duplexer formed by the junction of three waveguides : a first guide (7) and a second guide (8) having rectangular sections, a third guide (5) having a square section and used as a bidirectional path ; said first and second guides being arranged in such a manner that the electrical components of the electromagnetic fields are perpendicular ; said generator feeding one of the guides having rectangular sections ; the other junction being formed of the intersection between the first and second guides in the neighborhood of said mixer ; said stage forming a single block (20).

2. Hyperfrequency stage according to claim 1, characterized in that one of said first and second guides has a curved shape in its longitudinal direction.

3. Stage according to any of claims 1 and 2, characterized in that the mixer comprises two diodes (11, 12) contained in two modules and placed in such a manner that their metallizations are in facing relationship.

4. Stage according to any of claims 1 to 3, characterized in that the oscillator is formed by a module having a negative resistance, comprising a conductive carrier, a semiconductor diode contacting this carrier by one of its electrodes, a layer of dielectric material placed onto this carrier and surrounding the diode, and a metallization deposited onto this layer and contacting the other electrode of the diode.

5. Stage according to claim 4, characterized in that the oscillator further comprises a second module containing a variable capacity diode.

6. Transceiver comprising a stage according to any of claims 1 and 2, characterized in that it further comprises a horn aerial (3) connected to the guide having a square section.

7. Radar comprising a stage according to any of claims 1 and 2, characterized in that it comprises a horn aerial (3) connected to the guide having a square section, and further a quarter wavelength plate (4) placed between said guide having a square section and said aerial.

## Ansprüche

1. Hochfrequenzschaltungsblock mit wenigstens einem Millimeterwellen-Oszillator (9) zur Verwendung sowohl als Sendequelle als auch als Lokaloszillator, einem symmetrischen Mischer (10), dessen Ausgänge (101 und 102) zum Anschließen an die Eingänge eines Empfangsverstärkers (13) bestimmt sind, mehreren Teilen von Wellenleitern, in denen die gesendeten und empfangenen Wellen sich ausbreiten, und zwei Zusammenführungen, welche mit Abschnitten der genannten Wellenleiter zusammenwirken, dadurch gekennzeichnet, daß eine der Zusammenführungen (6) ein Polarisationsduplexer ist, der aus der Zusammenführung von drei Wellenleitern gebildet ist : einem ersten Leiter (7) und einem zweiten Leiter (8), die rechtwinklige Querschnitte aufweisen, einem dritten Leiter (5) mit quadratischem Querschnitt, der als Zweirichtungszweig dient ; wobei der erste und der zweite Leiter derart angeordnet sind, daß die elektrischen Komponenten der elektromagnetischen Felder senkrecht zueinander sind ; wobei der genannte Generator einen der Leiter mit rechtwinkligem Querschnitt speist ; während die andere Zusammenführung aus dem Schnitt zwischen dem ersten und dem zweiten Leiter in der Nähe des genannten Mischers gebildet ist ; wobei der Schaltungsblock eine einzige Baugruppe (20) bildet.

2. Hochfrequenzschaltungsblock nach Anspruch 1, dadurch gekennzeichnet, daß von dem ersten oder zweiten Wellenleiter einer in Längsrichtung eine gekrümmte Form aufweist.

3. Schaltungsblock nach Anspruch 1 oder 2, dadurch gekennzeichnet, daß der Mischer zwei Dioden (11, 12) umfaßt, die in zwei Moduln enthalten und derart angeordnet sind, daß ihre Metallisierungen einander zugewendet sind.

4. Schaltungsblock nach einem der Ansprüche 1 bis 3, dadurch gekennzeichnet, daß der Oszillator aus einem Modul mit negativem Widerstand gebildet ist, welcher einen leitfähigen Träger, eine Halbleiterdiode, die mit einer ihrer Elektroden mit diesem Träger in Berührung ist, eine Schicht aus dielektrischem Material, welche auf diesem Träger angeordnet ist und die Diode umgibt, und eine Metallisierung umfaßt, welche auf dieser Schicht aufgebracht ist und in Berührung mit der anderen Elektrode der Diode ist.

5. Schaltungsblock nach Anspruch 4, dadurch gekennzeichnet, daß der Oszillator ferner einen zweiten Modul umfaßt, welcher eine Diode mit variabler Kapazität enthält.

6. Sender/Empfänger mit einem Schaltungsblock nach einem der Ansprüche 1 und 2, dadurch gekennzeichnet, daß er ferner einen Hornstrahler (3) umfaßt, der an den Leiter mit quadratischem Querschnitt angeschlossen ist.

7. Radar mit einem Schaltungsblock nach einem der Ansprüche 1 und 2, dadurch gekennzeichnet, daß es einen Hornstrahler enthält, der an den Leiter mit quadratischem Querschnitt angeschlossen ist, und ferner eine Viertelwellenlängenscheibe (4) aufweist, welche zwischen dem einen quadratischen Querschnitt aufweisenden Leiter und dem Strahler angeordnet ist.

FIG. 1

FIG. 2

Fig. 3